(19) **Europäisches Patentamt / European Patent Office / Office européen des brevets**

(11) **EP 1 679 389 B1**

(12) **FASCICULE DE BREVET EUROPEEN**

(45) Date de publication et mention de la délivrance du brevet:
**24.07.2013 Bulletin 2013/30**

(51) Int Cl.:
*C23C 14/08* (2006.01)  *C03C 17/34* (2006.01)
*G02B 1/11* (2006.01)

(21) Numéro de dépôt: **06112782.5**

(22) Date de dépôt: **19.09.2001**

(54) **Substrat à revêtement photocatalytique**

Substrat mit einer photokatalytischen Beschichtung

Substrate with photocatalytic coating

(84) Etats contractants désignés:
**AT BE CH CY DE DK ES FI FR GB GR IE IT LI LU MC NL PT SE TR**

(30) Priorité: **20.09.2000 FR 0011959**

(43) Date de publication de la demande:
**12.07.2006 Bulletin 2006/28**

(62) Numéro(s) de document de la (des) demande(s) initiale(s) en application de l'article 76 CBE:
**01972163.8 / 1 319 092**

(73) Titulaire: **SAINT-GOBAIN GLASS FRANCE**
**92400 Courbevoie (FR)**

(72) Inventeurs:
• **Nadaud, Nicolas**
  **94250 Gentilly (FR)**
• **Talpaert, Xavier**
  **75019 Paris (FR)**
• **Rondeau, Véronique**
  **92600 Asnières sur Seine (FR)**

(74) Mandataire: **Teyssedre, Laurent et al**
**Saint-Gobain Recherche**
**39, quai Lucien Lefranc**
**B.P. 135**
**93303 Aubervilliers Cedex (FR)**

(56) Documents cités:
**EP-A- 0 901 991     WO-A-00/27771**

**Description**

L'invention concerne des substrats généralement transparents ou semi-transparents, notamment en verre, en matériau plastique, en vitrocéramique, et qu'on munit de revêtement à propriétés photocatalytiques pour leur conférer une fonction anti-salissures ou, plus exactement, auto-nettoyante.

Une application importante de ces substrats concerne des vitrages, qui peuvent être d'applications très diverses, des vitrages utilitaires aux vitrages utilisés dans l'électroménager, des vitrages pour véhicules aux vitrages pour bâtiments.

Elle s'applique aussi aux vitrages réfléchissants du type miroir (miroir pour habitations ou rétroviseur de véhicule) et aux vitrages opacifiés du type allège.

L'invention s'applique aussi, similairement, aux substrats non transparents, comme des substrats de céramique ou tout autre substrat pouvant notamment être utilisé comme matériau architectural (métal, carrelages ...). Elle s'applique de préférence, quelle que soit la nature du substrat, à des substrats sensiblement plans ou légèrement bombés.

Les revêtements photocatalytiques ont déjà été étudiés, notamment ceux à base d'oxyde de titane cristallisé sous forme anatase. Leur capacité à dégrader les salissures d'origine organique ou les micro-organismes sous l'effet de rayonnement U.V. est très intéressante. Ils ont aussi souvent un caractère hydrophile, qui permet l'évacuation des salissures minérales par projection d'eau ou, pour les vitrages extérieurs, par la pluie.

Ce type de revêtement aux propriétés anti-salissures, bactéricides, algicides, a déjà été décrit, notamment dans le brevet WO97/10186, qui en décrit plusieurs modes d'obtention.

L'invention a pour but d'améliorer l'aspect du revêtement, plus particulièrement d'améliorer les propriétés optiques du substrat qui en est muni.

L'invention peut être obtenue par un procédé de dépôt par pulvérisation cathodique d'un revêtement à propriétés photocatalytiques comprenant de l'oxyde de titane au moins partiellement cristallisé sous forme anatase sur un substrat porteur transparent ou semi-transparent. La caractéristique de ce procédé consiste à réaliser la pulvérisation sur le substrat, sous une pression de dépôt d'au moins 2 Pascals. Elle est de préférence d'au plus 6,67 Pa et notamment d'au moins 2,67 Pa (c'est-à-dire au moins 15 millitors, notamment entre 20 et 50 millitors).

En effet, comme cela est connu du brevet WO97/10186 précité, on peut déposer ce type de revêtement par pulvérisation cathodique. C'est une technique sous vide qui permet, notamment, d'ajuster très finement les épaisseurs et la stoechiométrie des couches déposées. Elle est généralement assistée par champ magnétique pour plus d'efficacité. Elle peut être réactive : on part alors d'une cible essentiellement métallique, ici à base de titane (éventuellement allié à un autre métal ou à du silicium), et la pulvérisation se fait en atmosphère oxydante, généralement un mélange $Ar/O_2$. Elle peut aussi être non réactive, on part alors d'une cible dite céramique qui est déjà sous la forme oxydée du titane (éventuellement alliée).

Cependant, les couches obtenues par ce type de technique sont généralement amorphes, alors que la fonctionnalité du revêtement selon l'invention est directement liée au fait qu'il doit être significativement cristallisé. C'est la raison pour laquelle, comme cela est préconisé dans le brevet précité, on a besoin de cristalliser (ou d'augmenter le taux de cristallisation) du revêtement en lui faisant subir un traitement thermique, par exemple de l'ordre de 30 minutes à plusieurs heures à au moins 400°C.

Il a été montré qu'une pression aussi élevée favorisait une cristallisation particulière de la couche, un niveau de densité/de rugosité qui avaient un impact significatif sur le niveau des propriétés photocatalytiques du revêtement. Dans certains cas, le recuit peut devenir optionnel. Pour donner un ordre d'idée, les pressions de dépôt généralement utilisées pour des oxydes métalliques sont usuellement dans la gamme des 2 à 8 millitors (soit 0,27 à 1,07 Pa) : on choisit donc des pressions de dépôt tout-à-fait inhabituelles dans ce domaine.

Il a été également montré que l'on pouvait supprimer éventuellement l'étape de traitement postérieure au dépôt, ou tout au moins la rendre optionnelle (et/ou limiter en durée ou en température), en pulvérisant la couche sur le substrat chaud, et non pas à température ambiante, notamment à au moins 100°C. Ce chauffage lors du dépôt est alternatif ou cumulatif avec l'utilisation de pressions élevées mentionnée précédemment.

Ce chauffage présente au moins cinq avantages :

- un gain énergétique lors de la fabrication ,
- la possibilité d'utiliser des substrats qui ne pourraient pas supporter des traitements thermiques à des températures de 400 ou 500°C au moins sans dégradation,
- dans le cas où le recuit nécessitait d'interposer entre substrat et revêtement photocatalytique une couche barrière à la diffusion d'éléments du substrat (du type alcalins quand il s'agit de verre), la possibilité d'utiliser une couche barrière plus fine, voire de supprimer complètement la couche barrière, puisque le traitement thermique selon l'invention est beaucoup moins agressif qu'un recuit,
- un cycle de fabrication beaucoup plus court (puisque le traitement thermique du substrat est nettement moins long et à une température nettement plus basse),

- la suppression du stockage des produits " semi-finis " à recuire.

On obtient cependant des niveaux d'activité photocatalytique pour les revêtements tout-à-fait similaires à ceux des revêtements déposés puis recuits.

Or cela n'était pas un pari gagné d'avance, dans la mesure où l'on pouvait s'attendre à ce qu'un recuit prolongé soit indispensable pour faire croître progressivement les germes cristallisés au sein de la matrice d'oxyde amorphe. Tel n'a pas été le cas : un dépôt à chaud favorise le dépôt de la couche directement cristallisée au moins en partie.

Il n'était pas non plus évident que le revêtement ainsi déposé " à chaud " cristalliserait préférentiellement sous forme anatase plutôt que sous forme rutile (la forme anatase est bien plus photocatalytique que la forme rutile ou broockite de l'oxyde de titane).

Pour réaliser ce procédé, on a différentes variantes, notamment en fonction du type de dispositif de pulvérisation disponible. On peut ainsi chauffer le substrat préalablement au dépôt à proprement dit, hors de l'enceinte sous vide. On peut aussi chauffer le substrat lors du dépôt, quand la chambre de dépôt est équipée de moyens de chauffage adhoc. Le chauffage du substrat peut donc se faire avant et/ou pendant la pulvérisation du revêtement. Il peut aussi être progressif lors du dépôt, ou n'affecter qu'une partie de l'épaisseur de la couche déposée (par exemple la partie supérieure).

Avantageusement, le substrat se trouve, pendant la pulvérisation de la couche, à une température comprise entre 150 et 350°C, de préférence d'au moins 200°C et notamment entre 210 et 280°C. De façon surprenante, on a donc pu obtenir des couches suffisamment cristallisées sans avoir à chauffer le substrat jusqu'aux températures utilisées généralement pour faire des recuits, d'au moins 400°C à 500°C.

Généralement, quand le revêtement est essentiellement à base d'oxyde de titane ($TiO_2$), et quand on le dépose par pulvérisation cathodique (" à chaud " ou à température ambiante), il a un indice de réfraction assez élevé, supérieur à 2 ou à 2,1 ou à 2,15 ou 2,2. Il est généralement compris entre 2,15 et 2,35 ou entre 2,35 et 2,50 (il peut être légèrement sous-stoechiométrique), notamment entre 2,40 et 2,45. C'est une caractéristique assez spécifique de ce type de dépôt, car des revêtements de même nature déposés par d'autres techniques, par exemple par sol-gel, tendent à être beaucoup plus poreux et à avoir des indices de réfraction significativement moins élevés (en dessous de 2 et même en dessous de 1,8 ou 1,7). Le procédé permet d'obtenir des couches par pulvérisation cathodique qui présentent une porosité et/ou une rugosité (notamment une rugosité RMS comprise entre 2,5 et 10 nm amplifiant ses propriétés photocatalytiques. De ce fait, elles peuvent présenter des indices de réfraction de l'ordre de 2,15 ou 2,35, inférieures à ceux habituellement obtenus par pulvérisation cathodique, preuve indirecte de leur porosité. C'est un atout sur le plan optique, puisqu'elles ont, avec un indice de réfraction abaissé, un aspect moins réfléchissant à épaisseur donnée.

Il a été observé que la structure cristallographique des revêtements est influencé par le fait qu'ils sont déposés à froid puis recuits ou déposés à chaud. Ainsi, de manière assez inattendue, les revêtements déposés " à chaud " et/ou à haute pression, ont généralement une taille moyenne de cristallites de $TiO_2$ généralement inférieure ou égale à 50 ou à 40 ou à 30 nm, notamment comprise entre 15 et 30 nm ou entre 20 et 40 nm. Les revêtements déposés de façon standard, notamment " à froid " puis recuits, tendent à comporter des cristallites de taille supérieure, d'au moins 30 nm ou 40, généralement comprise entre 40 et 50 nm quand on utilise des pressions de dépôt standard.

Par contre, si on dépose le revêtement à température ambiante mais à haute pression, et que l'on fait ensuite une opération de recuit, la taille des cristallites est de taille plus faible (20-40 nm), et comparable à celle des cristallites des revêtements déposés à chaud, que ce soit à haute ou basse pression.

L'activité photocatalytique des revêtements déposés à température ambiante à haute pression puis recuits est bien meilleure que celle des revêtements déposés à température ambiante à basse pression, puis recuits : toutes choses égales par ailleurs, il est clair que la pression de dépôt influe sur les performances du revêtement, tout particulièrement en cas de dépôt " à froid ", et cela de façon marquante.

Un chauffage simultané avec la croissance de la couche entraîne la formation d'une micro-structure propice à une rugosité et/ou une porosité favorable à une propriété photocatalytique. C'est un peu le même cas quand on utilise une pression de dépôt élevée (avec un dépôt à " froid " suivi d'un recuit par exemple).

Grâce au procédé par dépôt à chaud et/ou à pression élevée, on peut obtenir des revêtements présentant une rugosité R.M.S. (Root Mean Square) mesurée par microscopie à force atomique, en faisant des mesures sur une même surface avec des pas de 2 micromètres :

- d'au moins 2 nm, notamment d'au moins 2,5 nm, de préférence entre 2,8 nm et 4,6 nm dans le cas de dépôts à température ambiante à haute pression au sens de l'invention (2 à 5 Pa), suivis de recuits,
- d'au moins 4 nm, notamment d'au moins 5 nm, de préférence entre 5,5 et 6,0 nm dans le cas de dépôt à chaud (environ 250°C) sans recuit, que ce soit à haute ou basse pression.

A titre de comparaison, la rugosité de revêtements déposés à température ambiante à pression standard (notamment 2.10-3 millibars, soit 0,2 Pa) puis recuits n'est que de 2 nm au mieux : cela prouve que l'utilisation de pressions élevées permet d'atteindre des rugosités étonnamment élevées pour des couches déposées par pulvérisation cathodique, ce qui a pour conséquence une amélioration des propriétés photocatalytiques du revêtement.

Le revêtement a une épaisseur géométrique entre 10 et 25 nm. Il s'est avéré que, même très mince, le revêtement pouvait présenter des propriétés photocatalytiques suffisantes (au moins pour certaines applications), avec en outre l'avantage optique d'être peu réfléchissant.

Comme on l'a vu plus haut, la pulvérisation cathodique du revêtement peut être réactive ou non réactive. Dans un cas comme dans l'autre, on peut doper la cible à pulvériser, notamment avec au moins un métal. Il peut s'agir d'un ou plusieurs métaux choisis dans la liste suivante : Nb, Ta, Fe, Bi, Co, Ni, Cu, Ru, Ce, Mo, Al.

Le procédé de dépôt peut être précédé et/ou suivi d'une ou plusieurs étapes de dépôt d'autre(s) couche(s) mince(s), notamment à fonction optique, anti-statique, anti-couleur, anti-réfléchissante, hydrophile, protectrice, ou pour amplifier la rugosité du revêtement à propriétés photocatalytiques. On a ainsi observé que l'on peut avoir avantage à déposer une (au moins) couche de façon à ce qu'elle soit particulièrement rugueuse, par exemple par pyrolyse ou sol-gel, puis le revêtement photocatalytique ; le revêtement tend alors à " suivre " la rugosité de la couche sous-jacente et à présenter de fait, lui aussi, une rugosité significative, alors que les couches déposées par pulvérisation cathodique ont plutôt tendance à être peu rugueuses. On peut ainsi faire des empilements avec une sous-couche (de rugosité R.M.S. de par exemple au moins 5 ou 10 nm), de type $SiO_2$, SiOC ou SiON déposée par pyrolyse en phase gazeuse (CVD), puis la couche photocatalytique par pulvérisation cathodique.

Le procédé comprend donc toute combinaison entre le dépôt d'une ou plusieurs couches par pulvérisation cathodique (dont le revêtement photocatalytique au moins) et le dépôt de la ou des autres couches de l'empilement par une technique impliquant une décomposition thermique, notamment une pyrolyse (en phase liquide, gazeuse ou pulvérulente) ou une technique par sol-gel.

Comme on l'a vu plus haut, les revêtements à base de $TiO_2$ photocatalytique ont un indice de réfraction élevé. Cela signifie qu'ils sont réfléchissants et qu'ils confèrent à leur substrat porteur un aspect réfléchissant considéré souvent comme peu esthétique. En outre, la couleur en réflexion, mis à part ce caractère brillant, peut être indésirable. Il n'est pas simple d'améliorer cet aspect en réflexion, car la fonctionnalité photocatalytique présente des contraintes : Le revêtement doit généralement être au contact de l'atmosphère extérieure pour recevoir des U.V. et dégrader les salissures extérieures. On ne peut donc pas le surmonter d'une couche à bas indice (à moins qu'elle soit très mince et/ou poreuse). Il doit aussi avoir une épaisseur minimale donnée pour être suffisamment efficace.

La présente invention a donc consisté à améliorer l'aspect en réflexion du substrat, sans perturber l'activité photocatalytique du revêtement, notamment en abaissant au mieux sa réflexion lumineuse et/ou en lui conférant une couleur en réflexion qui soit la plus neutre possible.

L'invention a donc pour objet le substrat transparent ou semi-transparent défini précédemment et qui est muni sur au moins une partie d'au moins une de ses faces d'un revêtement photocatalytique comportant de l'oxyde de titane au moins partiellement cristallisé anatase, ce revêtement ayant un haut indice de réfraction, d'au moins 2 ou 2,1 ou 2,2. Selon l'invention, ce revêtement est considéré comme faisant partie d'un empilement de couches minces antireflets, le revêtement en étant la dernière couche (c'est-à-dire la couche la plus éloignée du substrat porteur). L'empilement antireflets est composé d'une alternance de couches à haut et bas indice, et s'achève donc dans le cas présent par la couche à haut indice photocatalytique. Ce terme " d'antireflet " est utilisé par commodité : généralement, il est employé quand on cherche à obtenir une réflexion lumineuse inférieure à celle qu'on aurait avec le substrat seul. Dans le contexte de l'invention, il s'agit plus de limiter l'augmentation de réflexion lumineuse (et/ou de modifier ou atténuer sa couleur en réflexion) provoquée par l'utilisation d'un revêtement contenant de l'oxyde de titane.

Au sens de l'invention, on entend par " couche " une couche unique ou un superposition de couches. S'il s'agit d'une superposition de couches, on considère que son épaisseur globale est la somme des épaisseurs de chacune des couches et que son indice global est la moyenne de l'ensemble des indices de réfraction desdites couches. Cela s'applique aussi au revêtement photocatalytique. Il peut aussi être associé à une autre couche à haut indice.

Au sens de l'invention et comme rappelé plus haut, on entend par " antireflets " la fonction qui permet d'abaisser la valeur de réflexion lumineuse du substrat revêtu, et/ou d'atténuer sa couleur en réflexion, notamment pour la rendre la plus pâle et la plus neutre, la plus esthétique possible (on parle alors aussi d'effet " anti-couleur").

Cela est une adaptation assez libre et inattendue des empilements antireflets conventionnels. En effet, de façon connue, ces empilements alternent des couches à haut et bas indices et s'achèvent par des couches à bas indice (le plus proche possible de l'indice de réfraction, égal à 1, de l'air) et qui sont généralement des couches à base de $SiO_2$, de $MgF_2$... Or ici, l'empilement s'achève par une couche à haut indice, ce qui est assez paradoxal. Pourtant, en sélectionnant de façon appropriée les caractéristiques des différentes couches, cet empilement antireflets particulier parvient à atténuer de façon significative le caractère réfléchissant intrinsèque au $TiO_2$ à haut indice, et à donner au substrat une couleur en réflexion acceptable (neutre, dans des teintes pâles évitant les rouges et autres couleurs chaudes, jugées peu esthétiques, au profit du gris, du bleu , ou du vert notamment).

Avantageusement, le revêtement photocatalytique a un indice de réfraction supérieur ou égal à 2,30, notamment compris entre 2,35 et 2,50, ou entre 2,40 et 2,45 (comme on l'a vu précédemment, on peut aussi le déposer de façon à ce qu'il ait un indice de seulement 2,10 à 2,30). Il est de préférence déposé par pulvérisation cathodique. On sélectionne avantageusement son épaisseur optique, conjointement avec celles des autres couches de l'empilement, afin d'abaisser la réflexion lumineuse du substrat. utilise des couches entre 10 et 25 nm d'épaisseur géométrique.

Suivant que le revêtement est déposée par pulvérisation " à chaud " ou à température ambiante froid et recuit, il contient des cristallites de taille variable comme on l'a vu plus haut (généralement moins de 30 nm " à chaud ", et de l'ordre de 30 à 50 nm ou plus à température ambiante à pression standard, comme vu plus haut ).

L'empilement antireflets de l'invention comprend trois couches, dont, successivement, une couche à haut indice, une couche à bas indice, puis le revêtement photocatalytique à haut indice.

La couches à haut indice de l'empilement à part le revêtement photocatalytique a un indice entre 1,9 et 2,3 ou entre 1,9 et 2,2. Il peut s'agir d'oxyde de zinc, d'étain, de zirconium, de nitrure d'aluminium ou de nitrure de silicium. Il peut s'agir aussi d'un mélange d'au moins deux de ces composés.

On sélectionne l'épaisseur optique de la couches à haut indice. On choisit une épaisseur géométrique entre 10 et 20 nm.

La couche à bas indice a un indice compris entre 1,4 et 1,75, notamment entre 1,45 et 1,65. Elle peut être par exemple à base d'oxyde de silicium, d'oxyde d'aluminium ou d'un mélange des deux. On sélectionne l'épaisseur optique de ces couches à bas indice : leur épaisseur optique optimale est de préférence aux environs de $\lambda/20$ avec $\lambda$ vers 580 nm. Cela correspond à une épaisseur optique comprise entre 20 et 79 nm, notamment entre 19 et 39 nm, notamment entre 25 et 35 nm, et à une épaisseur géométrique comprise entre 12 et 50 nm, notamment entre 15 et 30 nm, par exemple entre 20 et 28 nm.

Comme évoqué plus haut, ces différentes sélections d'épaisseurs optiques prennent en compte l'ensemble de l'aspect en réflexion du substrat : on s'efforce non seulement de baisser la valeur de réflexion lumineuse $R_L$ mais également de lui conférer une teinte jugée esthétique de nos jours (c'est-à-dire plutôt dans les couleurs froides que vers le jaune ou le rouge) et la moins intense possible. Il faut donc trouver le meilleur compromis pour que, dans son ensemble, l'aspect en réflexion du substrat soit meilleur. Suivant les applications, peut être privilégié plutôt l'abaissement de la valeur de $R_L$ ou plutôt la sélection d'une colorimétrie particulière en réflexion (par exemple quantifiée par les valeurs de a* et b* du système de colorimétrie L, a* ,b* ou par la valeur de longueur d'onde dominante associée à la pureté de couleur).

Avantageusement, l'ensemble des couches de l'empilement antireflet peut être déposé par pulvérisation cathodique, l'une après l'autre, sur la même ligne de production.

Selon une variante optionnelle de l'invention, on peut insérer entre le substrat et l'empilement antireflets une couche barrière aux espèces susceptibles de diffuser du substrat. Il s'agit notamment des alcalins quand le substrat est en verre. Elle est, par exemple, à base d'oxyde (ou d'oxycarbure) de silicium : le $SiO_2$ peut être déposé par pulvérisation cathodique et le SiOC, de façon connue, par pyrolyse en phase gazeuse (CVD). Elle a de préférence une épaisseur d'au moins 50 nm, par exemple comprise entre 80 et 200 nm . Choisie dans ce type de matériau, à indice relativement faible (vers 1,45 à 1,55), elle est en fait, généralement, largement " neutre " sur le plan optique. L'oxyde de silicium peut contenir des éléments minoritaires, notamment choisis parmi Al, C, N.

L'invention a également pour objet le vitrage, notamment un vitrage simple (un substrat rigide), un vitrage feuilleté, un vitrage multiple du type double vitrage et qui comporte au moins un substrat revêtu de la façon décrite plus haut.

Ledit vitrage présente de préférence, grâce à l'effet antireflet de l'invention, une réflexion lumineuse $R_L$ (côté couches) qui reste d'au plus 20% notamment d'au plus 18%. De préférence, cette réflexion lumineuse a une teinte agréable dans les bleus ou verts, avec des valeurs de a* et b* dans le système de colorimétrie (L, a*, b*) négatives et notamment inférieures à 3 ou 2,5 en valeurs absolues. La teinte est ainsi d'une couleur à la fois agréable à l'oeil et pâle, peu intense.

Le vitrage peut comporter aussi un ou plusieurs autres revêtements fonctionnels (déposés par pulvérisation cathodique ou pyrolyse ou sol-gel), soit sur la même face du substrat muni du revêtement photocatalytique, soit sur la face opposée de ce substrat, soit sur une face d'un autre substrat associé au premier dans un vitrage (double vitrage ou vitrage feuilleté). On peut aussi avoir un double vitrage du type verre/lame de gaz/verre avec sur la ou les faces extérieures des verres le revêtement photocatalytique et sur les faces internes (tournées vers la lame de gaz) un empilement à une ou deux couches d'argent. Le même type de configuration s'applique aux feuilletés.

Le ou les autres revêtements fonctionnels peuvent être, notamment, un revêtement anti-salissures, anti-solaire, bas-émissif, chauffant, hydrophobe, hydrophile, antireflet, anti-statique, un autre revêtement photocatalytique, .... On peut citer, notamment, les empilements anti-solaire ou bas-émissifs à une ou plusieurs couches d'argent, ou de nickel/ chrome ou de nitrure de titane ou de zirconium. Dans le cas des couches à base de nitrure métallique, on peut utiliser une technique CVD.

L'invention sera décrite ci-après plus en détail, avec des exemples de réalisation non limitatifs.

Les exemples 1 et 1 comparatif concernent le dépôt à chaud de couches de $TiO_2$ photocatalytique par pulvérisation cathodique.

**EXEMPLE 1** (Hors invention)

On a déposé sur un verre clair silico-sodo-calcique, de 4 mm d'épaisseur, une première couche de SiOC par CVD, de 80 nm, puis une seconde couche de $TiO_2$ photocatalytique de 90 nm, (on peut aussi substituer à la couche de SiOC une couche de $SiO_2$ :Al obtenue par pulvérisation cathodique réactive à partir d'une cible de Si dopé Al).

La couche de $TiO_2$ a été déposée par pulvérisation cathodique assistée par champ magnétique. Il s'agit d'une pulvérisation réactive, en présence d'oxygène à partir d'une cible de titane. Le verre est préchauffé à une température d'environ 220°C à 250°C. Cette température est maintenue constante à 5° près pendant la pulvérisation de la couche, à l'aide d'un dispositif chauffant placé en regard de la cible.

La couche de $TiO_2$ obtenue a un indice de réfraction de 2,44. Elle est cristallisée sous forme anatase (elle peut comporter aussi des zones amorphes), avec une taille moyenne de cristallites inférieure à 25 nm.

Son activité photocatalytique a été quantifiée à l'aide d'un test utilisant l'acide palmitique : Il s'agit de déposer une épaisseur donnée d'acide palmitique sur un revêtement photocatalytique, à exposer celui-ci à un rayonnement U.V. centré sur 365 nm avec une puissance surfacique d'environ 50 W/m2 pendant toute la durée du test, puis à mesurer la vitesse de disparition de l'acide palmitique selon la relation suivante :

$$V \ (nm.h^{-1}) = [\text{épaisseur acide palmitique (nm)}] \ / \ [2 \times t_{1/2} \ \text{disparition (h)}]$$

Avec la couche selon l'invention on obtient par ce calcul une activité photocatalytique d'au moins 10 $nm.h^{-1}$, notamment d'au moins 20 $nm.h^{-1}$, notamment comprise entre 20 et 100 $nm.h^{-1}$, selon le choix des paramètres de dépôt du type pression, température.

Le verre ainsi revêtu des deux couches présente, selon l'Illuminant $D_{65}$, une réflexion lumineuse $R_L$ de 23%, avec des valeurs de a* et b* en réflexion selon le système de colorimétrie (L, a*, b*) de l'ordre de 17 et 28 respectivement.

L'activité photocatalytique de la couche est donc intéressante, mais son aspect optique encore nettement réfléchissant, avec une couleur trop intense.

A noter qu'il est possible d'augmenter l'activité photocatalytique de la couche en lui faisant subir après dépôt un recuit conventionnel (d'une ou plusieurs heures à au moins 400°C).

**EXEMPTE COMPARATIF 1** (Hors invention)

On répète l'exemple 1, mais cette fois la couche de $TiO_2$ est déposée sur un substrat non chauffé, puis traitée quatre heures à environ 500 à 550°C. En outre, la sous-couche en $SiO_2$ est épaissie jusqu'à 100 nm. La morphologie de la couche est un peu différente, avec une taille moyenne de cristallites plutôt supérieure à 30 nm.

Son activité photocatalytique est similaire à celle de la couche de l'exemple 1 sans recuit, mais lui est inférieure si on choisit une épaisseur moindre de sous-couche de $SiO_2$.

Cela confirme donc que le dépôt " à chaud " selon l'invention, permettant " d'économiser " une opération souvent longue de recuit, ne s'obtient pas au détriment des performances de la couche. Cela confirme aussi un avantage subsidiaire de l'invention : en déposant à chaud, en évitant un recuit, on peut utiliser, à performances photocatalytiques identiques, une sous-couche barrière plus mince (d'où, là encore, un temps et un coût de fabrication du produit diminués).

Les exemples 2 et suivants concernent l'incorporation de couche photocatalytique en $TiO_2$ à haut indice, notamment déposées par pulvérisation cathodique, dans des empilements antireflets pour en améliorer les propriétés optiques.

**EXEMPLE 2 - (REALISE)** (Hors invention)

On dépose sur un verre float silico-sodo-calcique de 4 mm d'épaisseur, l'empilement de couches suivant :

| Verre | / $Si_3N_4$ [(1)] | / $SiO_2$ [(2)] | / $TiO_2$ [(3)] | |
|---|---|---|---|---|
| | 30 nm | 22 nm | 104 nm | (épaisseurs géométriques) |

La couche (1) en $Si_3N_4$ est déposée par pulvérisation cathodique réactive en présence d'azote à partir d'une cible de Si dopée Al.

La couche (2) de $SiO_2$ est déposée par pulvérisation cathodique réactive en présence d'oxygène à partir d'une cible de Si dopée Al.

La couche (3) de $TiO_2$ est photocatalytique et a été déposée à chaud comme décrit dans l'exemple 1.

Optionnellement, on peut insérer une couche supplémentaire entre le verre et la couche de $Si_3N_4$, une couche

de SiO$_2$ d'environ 100 nm obtenue comme l'autre couche de SiO$_2$ (2) décrite plus haut. Elle n'a quasiment pas d'influence sur les propriétés optiques du substrat et peut servir de couche barrière aux alcalins vis à vis du verre. Elle est optionnelle, d'autant plus que les couches du revêtement antireflets sous la couche photocatalytique, à savoir les couches (1) et (2) constituent elles-mêmes des couches barrières tout à fait satisfaisantes, outre leurs propriétés optiques : ces deux couches forment déjà un barrage de 100 nm aux espèces susceptibles de diffuser hors du verre.

L'activité photocatalytique de la couche 3 est de 80 nm.h$^{-1}$.

Alternativement, on peut utiliser une couche de TiO$_2$ déposée à froid puis recuite comme décrit dans l'exemple 1 comparatif .

En réflexion côté couches, le résultat pour un tel empilement est le suivant :

| | |
|---|---|
| R$_L$ (selon l'Illuminant D$_{65}$) : | 17,3% |
| a* (R$_L$) = | -2 |
| b*(R$_L$)= | -2,8 |
| $_d$(nm) = | 494 nm (longueur d'onde dominante de la réflexion lumineuse) |
| e (%) = | 2,5 % (pureté de la couleur en réflexion). |

On voit, par rapport à l'exemple 1, une baisse significative de la valeur de R$_L$, on obtient ici une couleur dans les bleus-verts, plutôt pâle. Globalement, on a donc un aspect en réflexion esthétiquement et sensiblement amélioré.

## EXEMPLE 3 (Hors invention)

Il est très proche de l'exemple 2, seule change un peu l'épaisseur de la couche de TiO$_2$.

Ici, on a :

| Verre | / Si$_3$N$_4$ $^{(1)}$ | / SiO$_2$ $^{(2)}$ | / TiO$_2$ $^{(3)}$ | |
|---|---|---|---|---|
| | 30 nm | 22 nm | 99 nm | (épaisseurs géométriques) |

Le résultat en réflexion lumineuse est le suivant (avec les mêmes conventions que pour l'exemple 2) :

| | |
|---|---|
| R$_L$ = | 17,9% |
| a* = | -0,8 |
| b* = | -0,7 |
| $_d$(nm) = | 494 nm |
| e (%) = | 0,8 % |

On a donc ici un compromis un peu différent, avec une valeur de R$_L$ légèrement supérieure mais des valeurs de a* et b* inférieures en valeurs absolues.

## EXEMPLE 4 - (MODELISATION) (Hors invention)

Il est très proche de l'exemple 2, seule change l'épaisseur de la première couche en Si$_3$N$_4$ :

| Verre | / Si$_3$N$_4$ $^{(1)}$ | / SiO$_2$ $^{(2)}$ | / TiO$_2$ $^{(3)}$ | |
|---|---|---|---|---|
| | 25 nm | 22 nm | 104 nm | (épaisseurs géométriques) |

Le résultat en réflexion lumineuse est le suivant (toujours avec les mêmes conventions) :

| | |
|---|---|
| R$_L$ = | 15,8% |
| a* = | 0 |
| b* = | -9 |
| $_d$(nm) = | 475 nm |
| e (%) = | 4,9% |

Ici on a fortement abaissé la valeur de R$_L$, mais la couleur en réflexion a changé de teinte.

## EXEMPLE 5 - (MODELISATION/COMPARATIF)

Ici, par rapport à l'exemple 2, toutes les épaisseurs changent.

On a :

| Verre | / $Si_3N_4$ [(1)] | / $SiO_2$ [(2)] | / $TiO_2$ [(3)] | |
|---|---|---|---|---|
| | 28 nm | 30 nm | 75 nm | (épaisseurs géométriques) |

Le résultat en réflexion lumineuse est le suivant :

$R_L$ = 25,8%
a* = -0,3
b* = -0,7
$_d$(nm) = 492 nm
e (%) = 0,5%

Si le substrat présente une couleur en réflexion satisfaisante, en revanche il a une valeur de $R_L$ bien au-delà de 20% qui est trop élevée : les épaisseurs choisies ne sont pas optimales.

## EXEMPLE 6 - (MODELISATION/COMPARATIF)

Ici on s'éloigne encore plus des épaisseurs de couches préconisées par l'invention, avec l'empilement suivant :

| Verre | / $Si_3N_4$ [(1)] | / $SiO_2$ [(2)] | / $TiO_2$ [(3)] | |
|---|---|---|---|---|
| | 20 nm | 20 nm | 60 nm | (épaisseurs géométriques) |

Le résultat en réflexion lumineuse est le suivant :

$R_L$ = 30%
a* = 2,3
b* = 7,2
$_d$(nm) = 587 nm
e (%) = 14%

Il a à la fois une valeur de $R_L$ très élevée, une couleur en réflexion peu recherchée et en plus intense. Son aspect en réflexion n'est donc pas satisfaisant.

## EXEMPLE 7 - (REALISE) (Hors invention)

L'empilement est cette fois le suivant :

| Verre | / $SnO_2$ [(1)] | / $SiO_2$ [(2)] | / $TiO_2$ [(3)] | |
|---|---|---|---|---|
| | 30 nm | 27 nm | 105 nm | (épaisseurs géométriques) |

On a donc substitué au $Si_3N_4$ du $SnO_2$, déposé par pulvérisation cathodique réactive en présence d'oxygène à partir d'une cible d'étain.

Le résultat en réflexion lumineuse est le suivant :

$R_L$ = 17,4 %
a* = -2,8
b* = -2,7
$_d$(nm) = 496 nm
e (%) = 2,8%

L'aspect en réflexion est proche de celui obtenu à l'exemple 2.

**EXEMPLE 8 - (MODELISE)** (Hors invention)

Ici, on substitue aux deux premières couches une couche unique d'indice 1,84 en oxynitrure de silicium SiON.
On a donc l'empilement :

| Verre | / SiON / | / TiO$_2$ | |
|-------|----------|-----------|---|
| | 72 nm | 101 nm | (épaisseurs géométriques) |

Le résultat en réflexion lumineuse est le suivant :

| R$_L$ = | 17,4% |
|---------|-------|
| a* = | 0 |
| b* = | -1,08 |
| $_d$(nm) = | 480 nm |
| e (%) = | 1 % |

L'aspect en réflexion est donc satisfaisant.

**EXEMPLE 9 - (MODELISE)** (Hors invention)

Il réplique l'exemple 8, mais avec un indice de 1,86 pour la couche de SiON.
L'aspect en réflexion s'en trouve un peu modifié :

| R$_L$ = | 17,8 % |
|---------|--------|
| a* = | -1,1 |
| b* = | -1,5 |
| $_d$(nm) = | 494 nm |
| e (%) = | 1,3 % |

**EXEMPLE 10 (REALISE)** (Hors invention)

On a l'empilement :

| Verre | / Si$_3$N$_4$ | / SiO$_2$ | / Si$_3$N$_4$ | / TiO$_2$ [3] |
|-------|---------------|-----------|---------------|--------------|
| | 24 nm | 17,5 nm | 24 nm | 92,5 nm |

La dernière " couche " à haut indice est donc la superposition d'une couche de Si$_3$N$_4$ et de TiO$_2$. La réflexion lumineuse côté couches R$_L$ est entre 16,5 et 17,5%. L'activité photocatalytique est aux environs de 80 nm.h-1.

**EXEMPLE 11 (REALISE)**

Il reprend le type d'empilement de l'exemple 3, avec des épaisseurs différentes. Il s'agit de :

| Verre | / Si$_3$N$_4$ [1] | / SiO$_2$ [2] | / TiO$_2$ [3] |
|-------|-------------------|---------------|---------------|
| | 14,5 nm | 43 nm | 14,5 nm |

la réflexion lumineuse côté couches est entre 13 et 16%. Les variations optiques du substrat ainsi revêtu, si l'on fait varier de 3% chacune des couches de l'empilement, sont les suivantes :

| R$_L$ : | 0,8% |
|---------|------|
| a* (R$_L$) : | 0,3 |
| b* (R$_L$) : | 1,3 |

Cet exemple présente une activité photocatalytique d'environ 15 à 20 nm.h$^{-1}$.

Cet exemple est intéressant à plusieurs titres : il est très peu sensible aux variations d'épaisseur, il sera donc facile à produire industriellement. Il reste suffisamment photocatalytique, bien que la couche d'oxyde de titane soit très mince. Il est satisfaisant sur le plan colorimétrique.

En conclusion, l'invention a mis au point un nouveau type d'empilement antireflets/anti-couleurs s'achevant par une couche à haut indice, empilement simple à réaliser industriellement et atténuant notablement l'aspect réfléchissant du TiO$_2$ sans en dégrader les propriétés photocatalytiques. Elle permet d'obtenir des vitrages dans les bleus ou dans les verts pâle en réflexion

L'invention peut s'appliquer de la même façon à des revêtements photocatalytiques qui ne contiennent pas que du TiO$_2$.


**Revendications**

1. Substrat transparent ou semi-transparent, de type verre, vitrocéramique, substrat plastique, muni sur au moins une partie d'au moins une de ses faces d'un revêtement à propriétés photocatalytiques comportant de t'oxyde de titane au moins partiellement cristallisé, notamment sous forme anatase, **caractérisé en ce que** ledit revêtement a un haut indice de réfraction d'au moins 2 et une épaisseur géométrique comprise entre 10 et 25 nm, et **en ce qu'**il constitue la dernière couche d'un empilement de couches minces « antireflets » composé d'une alternance de couches à haut et bas indices de réfraction qui comprend trois couches, successivement une première couche à haut indice de réfraction ayant un indice entre 1,9 et 2,3 et une épaisseur géométrique comprise entre 10 et 20 nm, une seconde couche à bas indice de réfraction ayant un indice compris entre 1,40 et 1,75 et une épaisseur géométrique comprise entre 12 et 50 nm, puis le revêtement à propriétés photocatatytiques.

2. Substrat selon la revendication 1, **caractérisé en ce que** le revêtement à propriétés photocatalytiques a un indice de réfraction supérieur ou égal à 2,30, notamment compris entre 2,35 et 2,50.

3. Substrat selon la revendication 1, **caractérisé en ce que** le revêtement à propriétés photocatalytiques a un indice de réfraction inférieur ou égal à 2,30, notamment compris entre 2,15 et 2,25.

4. Substrat selon l'une des revendications précédentes, **caractérisé en ce que** le revêtement à propriétés photocatalytiques est déposé par pulvérisation cathodique sous une pression P d'au moins 2 Pa.

5. Substrat selon l'une des revendications précédentes, **caractérisé en ce que** la couche à haut indice est à base d'oxyde d'étain, d'oxyde de zinc, d'oxyde de zirconium, de nitrure d'aluminium ou de nitrure de silicium ou à base d'un mélange d'au moins deux de ces composés.

6. Substrat selon la revendication précédente, **caractérisé en ce que la** couche à haut indice est à base de nitrure de silicium.

7. Substrat selon l'une des revendications précédentes, **caractérisé en ce que** la couche à bas indice de réfraction est à base d'oxyde de silicium, d'oxyde d'aluminium, ou d'un mélange des deux.

8. Substrat selon la revendication précédente, **caractérisé en ce que la** couche à bas indice de réfraction est à base d'oxyde de silicium.

9. Substrat selon l'une des revendications précédentes, **caractérisé en ce qu'**une couche barrière aux espèces susceptibles de diffuser du substrat, du type alcalins, est interposée entre ledit substrat et l'empilement antireflets.

10. Substrat selon la revendication précédente, **caractérisé en ce que la** couche barrière est à base d'oxyde de silicium, contenant éventuellement Al, C ou N, avec notamment une épaisseur d'au moins 50 nm, par exemple comprise entre 60 ou 80 nm et 200 nm.

11. Vitrage, notamment vitrage simple, vitrage feuilleté, vitrage multiple du type double vitrage, **caractérisé en ce qu'**il comporte au moins un substrat selon l'une des revendications précédentes.

12. Vitrage selon la revendication précédente, **caractérisé en ce qu'**il présente une réflexion lumineuse R$_L$ côté couches d'au plus 20%, notamment d'au plus 18%.

**13.** Vitrage selon la revendication 11 ou la revendication 12, **caractérisé en ce qu'il** présente une réflexion lumineuse côté couches dans les bleus ou les verts, avec des valeurs de a* et b* dans le système de colorimétrie (L, a*, b*) négatives et de préférence inférieures à 3 ou 2,5 en valeurs absolues.

**14.** Vitrage selon la revendication 11, **caractérisé en ce qu'il** comporte également au moins un autre revêtement fonctionnel, notamment anti-satissures, anti-solaire, bas-émissif, chauffant, hydrophobe, hydrophile, antireflet, anti-statique, ou un second revêtement à propriétés photocatalytiques.

**Patentansprüche**

**1.** Transparentes oder semitransparentes Substrat, vom Typ Glas, Glaskeramik, Kunststoffsubstrat, das auf wenigstens einem Teil wenigstens einer seiner Seiten mit einer Beschichtung mit photokatalytischen Eigenschaften versehen ist, die wenigstens teilweise kristallisiertes Titandioxid, insbesondere in Anatasform umfasst, **dadurch gekennzeichnet, dass** die Beschichtung einen hohen Brechungsindex von wenigstens 2 und eine geometrische Dicke zwischen 10 und 25 nm aufweist und dass sie die letzte Schicht eines Stapels aus dünnen "Antireflex"-Schichten bildet, der aus einer Wechselfolge von Schichten mit hohen und niedrigen Brechungsindizes besteht, die drei Schichten, nacheinander eine erste Schicht mit hohem Brechungsindex, die einen Index zwischen 1,9 und 2,3 und eine geometrische Dicke zwischen 10 und 20 nm aufweist, eine zweite Schicht mit niedrigem Brechungsindex, die einen Index zwischen 1,40 und 1,75 und eine geometrische Dicke zwischen 12 und 50 nm aufweist, anschließend die Beschichtung mit photokatalytischen Eigenschaften umfasst.

**2.** Substrat nach Anspruch 1, **dadurch gekennzeichnet, dass** die Beschichtung mit photokatalytischen Eigenschaften einen Brechungsindex von über oder gleich 2,30, insbesondere zwischen 2,35 und 2,50 aufweist.

**3.** Substrat nach Anspruch 1, **dadurch gekennzeichnet, dass** die Beschichtung mit photokatalytischen Eigenschaften einen Brechungsindex von unter oder gleich 2,30, insbesondere zwischen 2,15 und 2,25 aufweist.

**4.** Substrat nach einem der vorstehenden Ansprüche, **dadurch gekennzeichnet, dass** die Beschichtung mit photokatalytischen Eigenschaften mittels Kathodenzerstäubung unter einem Druck P von wenigstens 2 Pa abgeschieden wird.

**5.** Substrat nach einem der vorstehenden Ansprüche, **dadurch gekennzeichnet, dass** die Schicht mit hohem Index auf der Basis von Zinnoxid, von Zinkoxid, von Zirkonoxid, von Aluminiumnitrid oder Siliziumnitrid oder auf der Basis einer Mischung aus wenigstens zwei dieser Verbindungen ist.

**6.** Substrat nach dem vorstehenden Anspruch, **dadurch gekennzeichnet, dass** die Schicht mit hohem Index auf der Basis von Siliziumnitrid ist.

**7.** Substrat nach einem der vorstehenden Ansprüche, **dadurch gekennzeichnet, dass** die Schicht mit niedrigem Brechungsindex auf der Basis von Siliziumoxid, von Aluminiumoxid oder einer Mischung aus beiden ist.

**8.** Substrat nach dem vorstehenden Anspruch, **dadurch gekennzeichnet, dass** die Schicht mit niedrigem Brechungsindex auf der Basis von Siliziumoxid ist.

**9.** Substrat nach einem der vorstehenden Ansprüche, **dadurch gekennzeichnet, dass** zwischen dem Substrat und dem Antireflex-Stapel eine Sperrschicht für Spezies, die aus dem Substrat ausdiffundieren können, vom Typ Alkali, eingefügt ist.

**10.** Substrat nach dem vorstehenden Anspruch, **dadurch gekennzeichnet, dass** die Sperrschicht auf der Basis von Siliziumoxid, das eventuell Al, C oder N enthält, insbesondere mit einer Dicke von wenigstens 50 nm, beispielsweise zwischen 60 oder 80 nm und 200 nm ist.

**11.** Verglasung, insbesondere Einfachverglasung, Verbundverglasung, Mehrfachverglasung vom Typ Doppelverglasung, **dadurch gekennzeichnet, dass** sie wenigstens ein Substrat nach einem der vorstehenden Ansprüche umfasst.

**12.** Verglasung nach dem vorstehenden Anspruch, **dadurch gekennzeichnet, dass** sie eine schichtenseitige Lichtreflexion R_L von höchstens 20 %, insbesondere von höchstens 18 % aufweist.

13. Verglasung nach Anspruch 11 oder Anspruch 12, **dadurch gekennzeichnet, dass** sie eine schichtenseitige Lichtreflexion in den blauen oder grünen Farben aufweist, mit Werten von a* und b* im Farbmesssystem (L, a*, b*), die negativ und vorzugsweise kleiner als 3 oder 2,5 als Absolutwerte sind.

14. Verglasung nach Anspruch 11, **dadurch gekennzeichnet, dass** sie auch wenigstens eine weitere Funktionsbeschichtung, insbesondere schmutzabweisende, Sonnenschutz-, niedrig emittierende, Heiz-, hydrophobe, hydrophile, Antireflex-, Antistatik-Beschichtung, oder eine zweite Beschichtung mit photokatalytischen Eigenschaften umfasst.

**Claims**

1. A transparent or semitransparent substrate, of the glass, glass-ceramic or plastic substrate type, provided over at least part of at least one of its faces with a coating having photocatalytic properties, comprising titanium oxide at least partially crystallized, especially in the anatase form, **characterized in that** said coating has a high refractive index of at least 2 and a geometrical thickness of between 10 and 25 nm, and **in that** it constitutes the final layer of a multilayer consisting of thin "antireflection" layers being composed of an alternation of layers having high and low refractive indices that comprises three layers, namely, in succession, a first layer having a high refractive index between 1.9 and 2.3 and a geometrical thickness of between 10 and 20 nm, a second layer having a low refractive index of between 1.40 and 1.75 and a geometrical thickness of between 12 and 50 nm, and the coating having photocatalytic properties.

2. The substrate as claimed in claim 1, **characterized in that** the coating having photocatalytic properties has a refractive index of greater than or equal to 2.30, especially between 2.35 and 2.50.

3. The substrate as claimed in claim 1, **characterized in that** the coating having photocatalytic properties has a refractive index of less than or equal to 2.30, especially between 2.15 and 2.25.

4. The substrate as claimed in one of the preceding claims, **characterized in that** the coating having photocatalytic properties is deposited by sputtering at a pressure of at least 2 Pa.

5. The substrate as claimed in one of the preceding claims, **characterized in that** the high-index layer is based on tin oxide, zinc oxide, zirconium oxide, aluminum nitride or silicon nitride or based on a mixture of at least two of these compounds.

6. The substrate as claimed in the preceding claim, **characterized in that** the high-index layer is based on silicon nitride.

7. The substrate as claimed in one of the preceding claims, **characterized in that** the layer having a low refractive index is based on silicon oxide, aluminum oxide or a mixture of the two.

8. The substrate as claimed in the preceding claim, **characterized in that** the layer having a low refractive index is based on silicon oxide.

9. The substrate as claimed in one of the preceding claims, **characterized in that** a barrier layer blocking the species liable to diffuse out of the substrate, of the alkali metal type, is interposed between said substrate and the antireflection multilayer.

10. The substrate as claimed in the preceding claim, **characterized in that** the barrier layer is based on silicon oxide, possibly containing Al, C or N, especially with a thickness of at least 50 nm, for example between 60 or 80 nm and 200 nm.

11. A glazing, especially single glazing, laminated glazing or multiglazing of the double-glazing type, **characterized in that** it includes at least one substrate as claimed in one of the preceding claims.

12. The glazing as claimed in the preceding claim, **characterized in that** it has a light reflection R_L on the multilayer side of at most 20%, especially at most 18%.

**13.** The glazing as claimed in claim 11 or claim 12, **characterized in that** it has a light reflection, on the multilayer side, in the blues or the greens, with negative a* and b* values in the (L,a*,b*) colorimetry system which are preferably less than 3 or 2.5 in absolute values.

**14.** The glazing as claimed in claim 11, **characterized in that** it also includes at least one other functional coating, especially an antistaining, solar-protection, low-emissivity, heating, hydrophobic, hydrophilic, antireflection or antistatic coating, or a second coating having photocatalytic properties.

## RÉFÉRENCES CITÉES DANS LA DESCRIPTION

**Documents brevets cités dans la description**

- WO 9710186 A